(19) Europäisches Patentamt

European Patent Office

Office européen des brevets

(11) Veröffentlichungsnummer : **0 326 838 B1**

(12) **EUROPÄISCHE PATENTSCHRIFT**

(45) Veröffentlichungstag der Patentschrift :
**20.05.92 Patentblatt 92/21**

(21) Anmeldenummer : **89100645.4**

(22) Anmeldetag : **14.01.89**

(51) Int. Cl.⁵ : **C23C 14/50, H01J 37/20**

(54) Vorrichtung zur Halterung von Werkstücken.

(30) Priorität : **05.02.88 DE 3803411**

(43) Veröffentlichungstag der Anmeldung :
**09.08.89 Patentblatt 89/32**

(45) Bekanntmachung des Hinweises auf die
Patenterteilung :
**20.05.92 Patentblatt 92/21**

(84) Benannte Vertragsstaaten :
**CH DE FR GB IT LI NL**

(56) Entgegenhaltungen :
**DD-A- 245 207**
**DE-A- 2 513 604**
**DE-A- 3 307 572**
**DE-A- 3 605 486**

(73) Patentinhaber : **LEYBOLD
AKTIENGESELLSCHAFT
Wilhelm-Rohn-Strasse 25, Postfach 1555
W-6450 Hanau am Main 1 (DE)**

(72) Erfinder : **Helms, Dirk, Dr.
Kurt-Nonne-Weg 2
W-2070 Ahrensburg (DE)**
Erfinder : **Katzschner, Werner-Jürgen
Am Wingert 18
W-8762 Kleinkahl-Grosslaudenbach (DE)**
Erfinder : **Pawlakowitsch, Anton, Dr.
Pfaffenstättener Strasse 11
W-8755 Alzenau (DE)**
Erfinder : **Anderle, Friedrich
Reichenberger Strasse 51
W-6450 Hanau 1 (DE)**

**Beschreibung**

Die Erfindung betrifft eine Vorrichtung zur Halterung von Werkstücken, vorzugsweise von kreisscheibenförmigen, flachen Substraten in einer Vakuumkammer zum Zwecke einer Oberflächenbehandlung, insbesondere zum reaktiven Ionenätzen oder Beschichten mit Hilfe von Kathodenzerstäubung.

Bei einer bekannten Vorrichtung der in Frage stehenden Art wird das Substrat in einer ersten Phase in einer besonderen Be- und Entladestation, die in der Vakuumkammer angeordnet ist, einer Auflageplatte abgelegt, die am freien Ende eines um eine vertikale Achse schwenkbar gelagerten Tragarms angeordnet ist. Der Tragarm befördert dann das Substrat zusammen mit der Auflageplatte in einer zweiten Phase in den Bereich der Ionenquelle oder der Kathode. Nach erfolgter Oberflächenbehandlung wird dann der Tragarm wieder in einer dritten Phase zur Beladestation zurückgeschwenkt, wo das Substrat mit Hilfe eines Saughebers von der Auflageplatte abgehoben und einer Transportvorrichtung zugeführt wird. Diese bekannte Vorrichtung hat den Nachteil, daß sie vergleichsweise viel Platz in der Vakuumkammer beansprucht, daß sie langsam und geräuschvoll arbeitet, daß sie keine ausreichende Kühlung des Substrats ermöglicht und auch nicht in der Lage ist, das Substrat bei der Oberflächenbearbeitung zu drehen und in ihrer Stellung zur Ionenquelle oder zur Kathode zu verändern bzw. anzukippen.

Der vorliegenden Erfindung liegt nun die Aufgabe zugrunde, eine Vorrichtung der eingangs genannten Art zu schaffen, die die Nachteile bekannter Vorrichtungen größtenteils nicht aufweist, die besonders substratschonend und schnell arbeitet, sehr betriebssicher ist und die preiswert herstellbar ist.

Erfindungsgemäß wird diese Aufgabe gelöst durch eine mit einer Hohlwelle verbundenen Auflageplatte, einer unterhalb der Auflageplatte angeordneten Bodenplatte, die zusammen mit Abstandstücken und einem Spannring oder sich etwa parallel zur Ebene der Auflageplatte erstreckenden Fingern, einen die Auflageplatte teilweise umschließenden, koaxial zur Auflageplatte gehaltenen, verschiebbaren Käfig bildet, wobei das über einen in der Seitenwandung des Käfigs zwischen zwei Abstandstücken einführbare Substrat auf der Auflagefläche der Auflageplatte ablegbar ist und dort vom Spannring oder den Fingern nach einer Relativbewegung zwischen der Auflageplatte und dem Käfig arretierbar ist.

Vorzugsweise ist die die Auflageplatte tragende Hohlwelle mit Kanälen versehen, die einerseits mit Zu- und Ablaufleitungen und andererseits mit Kühlkanälen in der Auflageplatte oder einer Kammer korrespondieren, die zwischen der Auflagefläche und dem Substrat gebildet sind.

Um ein genaues Anlegen des Substrats auf der Auflagefläche zu ermöglichen, ist der Käfig über ein oder mehrere Stellglieder, beispielsweise über einen Hydraulik- oder Pneumatikzylinder, oder über mit Spindel-Mutter-Trieben ausgestattete Hubvorrichtungen gegenüber der Auflageplatte verschiebbar.

Hierzu ist außerdem ein Be- und Entladearm vorgesehen, der quer zur Längsachse der Hohlwelle bis in eine Öffnung oder einen Schlitz verfahrbar ist, der von zwei benachbarten Abstandstücken, dem Spannring und der Bodenplatte des Käfigs gebildet ist und dessen der Vorrichtung zugekehrtes Ende mit einer Halterung für das Substrat versehen ist, wobei die Halterung Öffnungen oder Aussparungen aufweist, durch die Hubstifte hindurchgreifen, die auf der Bodenplatte des Käfigs angeordnet sind und dabei mit dem Substrat in Kontakt treten und dieses von der Halterung abheben bzw. ablegen können.

Zweckmäßigerweise ist die Hohlwelle über einen Zahntrieb oder Zahnriementrieb von einem Motor antreibbar und hierzu in einem Lager im Gehäusedeckel gehalten, der Teil eines an der Vakuumkammerwand angeordneten Gehäuses ist, das der Halterung des Substrattisches dient, wobei das Gehäuse zur Halterung des Substrattisches um eine Achse schwenkbar am Gestell der Vorrichtung gelagert ist, die parallel zur Ebene der Auflagefläche der Auflageplatte verläuft.

Mit Vorteil ist die Bodenplatte auf mindestens einer Hubstange oder einem Stößel abgestützt, wobei Hubstange oder Stößel von einem Hubzylinder oder einer mechanisch arbeitenden, über einen Zahnriemen von einem Motor angetriebenen Hubvorrichtung bewegbar sind.

Die Hubstange ist dabei auf einem zweiarmigen Differentialhebel abgestützt, deren Enden mit den Kolbenstangen von Zylindern zusammenwirken, die in einen Druckmittelkreislauf eingeschaltet sind.

Um eine gute Kühlung des Substrats zu bewirken, weist die Hohlwelle mehrere achsparallele Kanäle auf, die in umlaufenden Nuten und/oder eine zentrale Öffnung münden, wobei die Bodenplatte des Käfigs mit Öffnungen oder Durchbrüchen versehen ist, durch die das kronenförmig ausgebildete, käfigseitige Ende der Hohlwelle mit seinen Zapfen hindurchgreift, wobei die Enden der Zapfen fest mit der Auflageplatte verbunden sind.

Zweckmäßigerweise münden an der Auflagefläche der Auflageplatte Kanäle ein, über die ein das Substrat kühlendes Gas in den Zwischenraum oder die Kammer, die vom Substrat und der Auflageplatte zumindest zeitweise gebildet sind, einströmen kann.

Die Erfindung läßt die verschiedensten Ausführungsmöglichkeiten zu; zwei davon sind in den anliegenden Zeichnungen schematisch dargestellt, und zwar zeigen:

Fig. 1 die Vorrichtung zum Beschichten von Substraten in einer Vakuumkammer

Fig. 2 den Längsschnitt durch einen Substrattisch mit Substrathalter für eine Vorrichtung, wie in Fig. 1 dargestellt

Fig. 3 den Schnitt nach den Linien C-D gemäß Fig. 2

Fig. 4 eine alternative Ausführungsform für eine Vorrichtung mit Substrattisch und Substrathalter im Schnitt

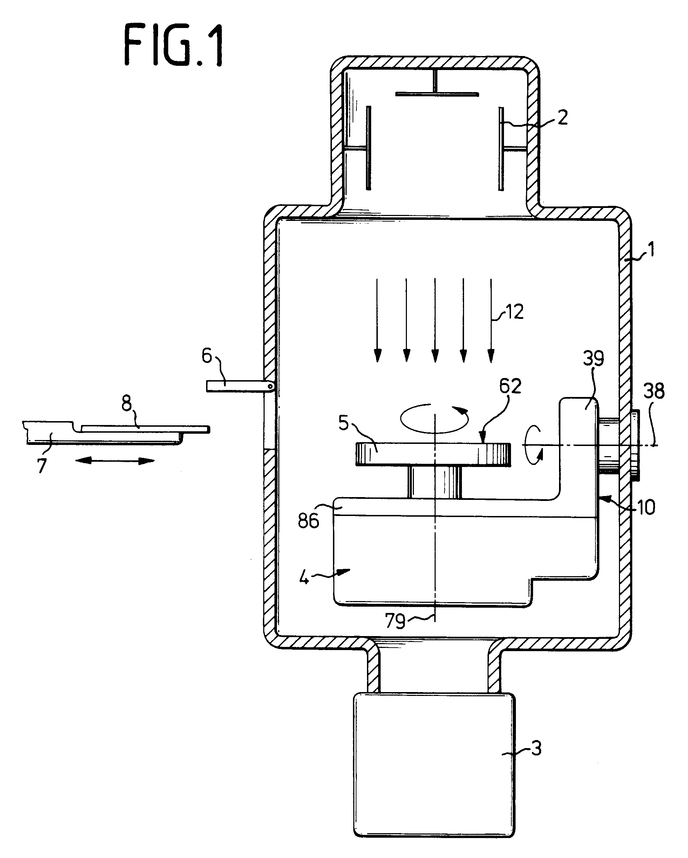

Die Vorrichtung gemäß Figur 1 für die Aufnahme von Substraten 8 in einer Vorrichtung zum reaktiven Ionenätzen besteht im wesentlichen aus der Vakuumkammer 1, der Ionenquelle 2, dem Pumpstand 3, dem Substrattisch 4, dem Substrathalter 5, der Schleusentür 6, dem Be- und Entladearm 7 und dem Substrat 8 (z. B. Siliziumscheibe). Der Substrathalter 5 ist um die Achse 79 drehbar im Substrattisch 4 gelagert, der über einen Haltearm 10, schwenkbar um die Achse 38, an der Wand der Vakuumkammer 1 gelagert ist. Mit der kontinuierlichen Drehung des Substrathalters 5 um die Achse 79 werden die nachteiligen Auswirkungen der Inhomogenitäten der Ionenstrahlen 12 auf den Ätzprozeß verringert. Die Achse 38 ermöglicht die Wahl eines für den Prozeß günstigen Anstellwinkels zwischen der Auflagefläche 62 und den Ionenstrahlen 12.

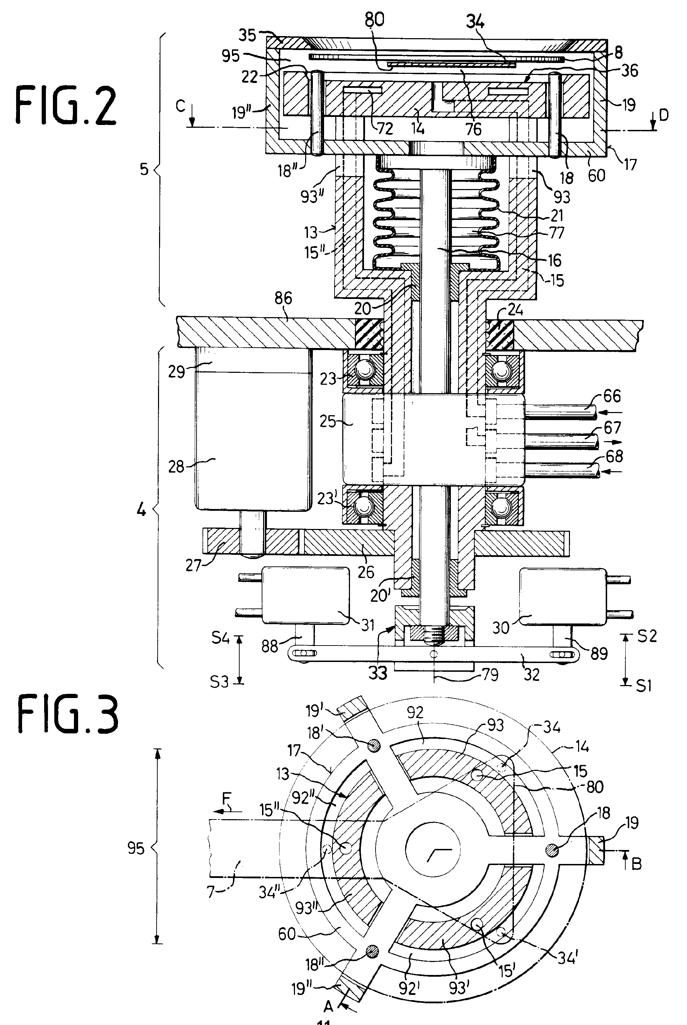

Gemäß Figur 2 ist der Probenhalter 5 am Gehäusedeckel 86 des Substrattisches 4 gehalten und geführt. Eine oben erweiterte und in drei Segmente übergehende Hohlwelle 13 trägt die Auflageplatte 14, wobei das obere Ende der Hohlwelle 13 kronenförmig ausgebildet ist und die einzelnen Zapfen 93, 93′, 93″ der Hohlwelle 13 durch Öffnungen 92, 92′, 92″ in der Bodenplatte 60 des Käfigs 17 hindurchgeführt sind. Die Auflageplatte 14 wird über zwei Kühlwasserkanäle 15, von denen nur einer dargestellt ist, mit einer Flüssigkeit gekühlt. Die Kühlflüssigkeit wird dabei über zwei Bohrungen in der Wandung der Hohlwelle 13 zu- bzw. abgeleitet. Ein dritter Kanal 15″ in der Hohlwelle 13 führt ein Kühlgas, z. B. Helium, zu, das in der Mitte der Auflageplatte 14 unterhalb des Substrats 8 austritt und dieses durch die Wärmeableitung auf die Auflageplatte 14 kühlt.

In der Hohlwelle 13 befindet sich die Hubstange 16, an deren oberem Ende der Käfig 17 befestigt ist. Dieser umgreift die Auflageplatte 14. Er besteht aus einem sternförmigen Unterteil oder einer Bodenplatte 60 mit drei Armen 17′, 17″, 17‴, die jeweils einen Hubstift 18, 18′, 18″ und ein Abstandstück 19, 19′, 19″ tragen.

Die Hubstange 16 wird durch zwei Gleitlager 20, 20′ geführt und durch den Balg 21 gegen Verdrehung gesichert. Außerdem dichtet der Balg 21 das Innere der Hohlwelle 13 gegen die Vakuumkammer 1 ab. Zwischen der Bodenplatte 60 und dem kronenförmig ausgebildeten, käfigseitigen Ende der Hohlwelle 13 kann auch ein Hubzylinder 77 angeordnet sein, der an eine geeignete Steuerhydraulik angeschlossen ist (nicht näher dargestellt). Die Hubstange 16 kann drei Stellungen - hoch, mittel, tief - einnehmen. In der Mittelstellung ist der Käfig 17 so weit gegenüber der Auflageplatte 14 angehoben, daß ein schmaler Be- und Entladearm 7 das scheibenförmige Substrat 8 durch den Schlitz 95 in den Käfig 17 schieben und mittig über der Aufnahmeplatte 14 positionieren kann. Die Hubstange 16 geht dann in die Stellung "hoch", wobei durch die Hubstifte 18, 18′, 18″ das Substrat 8 vom Arm 7 angehoben wird. Nachdem der Arm 7 in Pfeilrichtung F zurückgezogen wurde, senkt sich die Hubstange 16 in die untere Position und läßt dabei über die als Führungshilfe angeschrägten Innenkanten 22 der Aufnahmeplatte 14 das Substrat 8 in die Aufnahmelage gleiten. Durch den Spannring 35 wird das Substrat 8 schließlich fest auf die Auflagefläche 36 gedrückt.

Zum Entnehmen des Substrats 8 nach Durchführung des Ätzprozesses fährt die Hubstange 16 in die obere Position; der Arm 7 schiebt sich darunter, worauf durch Absenken der Hubstange 16 in die mittlere Position das Substrat 8 auf den Auflagenoppen 34, 34′, 34″ des Armes 7 abgelegt und anschließend seitlich herausgezogen wird.

Die Hohlwelle 13 ist im Substrattisch 4 mit Hilfe der Lager 23, 23′ gelagert. Die Abdichtung gegen das Vakuum erfolgt durch einen Dichtring 24, wobei eine ferrofluidische Dichtung bevorzugt wird. Die Hin- und Rückführung des Kühlwassers durch die Leitungen 15, 15′ bzw. den Wasserzulauf 68 und den Wasserablauf 67 und die Einleitung des Kühlgases über den Gaszulauf 66 in die Hohlwelle 13 erfolgen über eine Drehdurchführung 25. Angetrieben wird die Hohlwelle 13 über ein Zahnradpaar 26, 27 von einer Motorgetriebeeinheit 28. In letzterer ist ein Drehgeber 29 integriert, so daß die Stellung der Hohlwelle 13 gemessen werden kann. Damit ist es möglich, den Käfig 17 für die Be- und Entladevorgänge genügend genau auf den Arm 7 auszurichten. Die drei Stellungen der Hubstange 16 werden mit Hilfe zweier pneumatischer Zylinder 30, 31 erreicht, deren Kolbenstangen die Schaltstellungen S1, S2 bzw. S3, S4 einnehmen können. Die Zylinder 30, 31 können dabei mechanisch in Reihe angeordnet oder, wie in Figur 2 gezeigt, über einen Differentialhebel 32 gekoppelt sein. In diesem Fall wird die obere Position der Hubstange 16 durch die Schaltstellung S2, S4, die mittlere durch S1, S4 oder S2, S3 und die untere durch S1, S3 erzeugt. Die Krafteinleitung auf die Hubstange 16 erfolgt dabei über ein Drehlager 33, z. B. über ein Rillenkugellager, das eine freie Drehung der Hubstange 16 erlaubt, aber axiale Kräfte überträgt.

Die Figur 3 verdeutlicht in einer Ansicht von oben, wie der Einlegearm 7 im Käfig 17 bei Ablage oder Aufnahme des Substrats 8 positioniert ist.

Der Vorteil der Automatisierung des Substrattisches liegt zum einen darin, daß damit die Automatisierung der gesamten Vorrichtung ermöglicht wird, was eine Grundforderung an eine Produktionsanlage darstellt, und zum anderen, daß das Risiko der Partikelkontamination wesentlich reduziert wird. Insbesondere hat die erfindungsgemäße Vorrichtung den Vorteil, daß bei den Dreh- oder Hubbewegungen keine mechanische Reibung auftritt und damit keine Partikel erzeugt werden. Außerdem ist das Problem der Kühlung der Auflageplatte 14 und der Probe 8 in geeigneter Weise gelöst.

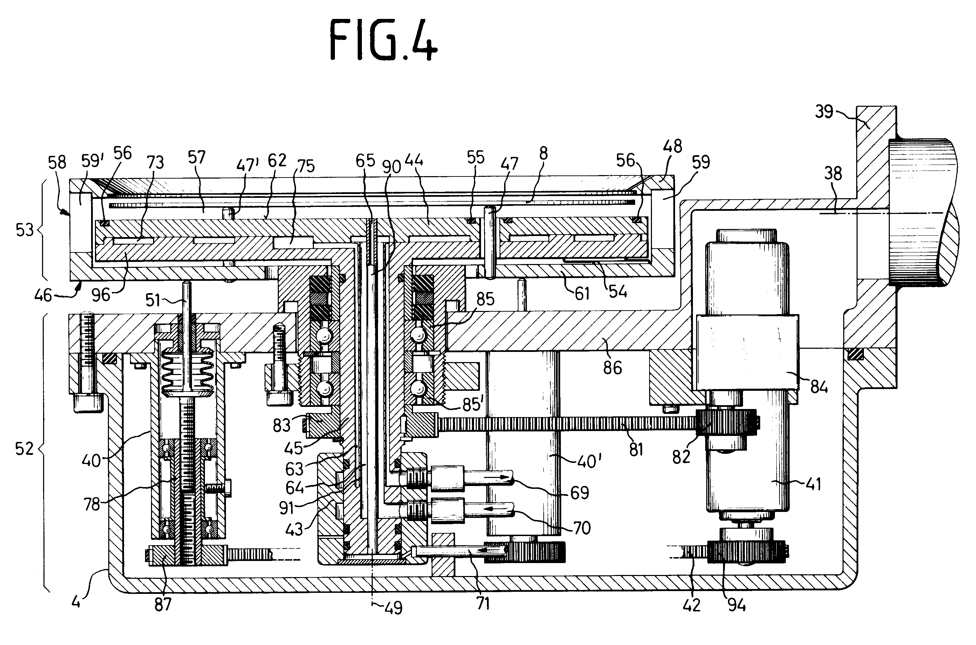

In Figur 4 ist eine weitere Ausführungsform der Erfindung schematisch dargestellt. Der Substrattisch 52 ist, schwenkbar um die Achse 38, auf einen Flansch 39 aufgebaut. Der Substrattisch 52 beinhaltet 3 Hubvorrichtungen 40, 40', 40", die durch einen Elektromotor 41 über einen Zahnriemen 42 angetrieben werden, eine Drehdurchführung 43 inklusive Lager und Dichtungssätzen, dem Substrathalter 53, rotierbar um die Achse 49, und einem Elektromotore 84 zur Rotation des Substrathalters über Zahnriemen 81. Der Substrathalter 53 besteht aus der wassergekühlten Auflageplatte 44, der Bodenplatte 61, der Hohlwelle 45 und dem Käfig 46 mit Hub- und Führungsstiften 47, 47', 47". In Ruhestelluung sind die Stößel 4051, 51', 51" der Hubvorrrichtungen 40, 40', 40" in den Probentisch 52 eingefahren. Der Käfig 46 wird durch die Blattfeder 54 nach unten gepreßt und klemmt mit seinem oberen Ring 48 das Substrat 8 auf die Auflageplatte 44. In der Platte 44 sind Dichtringe 55, 56 entlang des Umfangs der Auflageplatte 44 und um die Öffnungen 37 für die Hubstifte 47 angebracht. Sie haben die Aufgabe, im angedrückten Zustand des Substrats 8 eine Dichtung zwischen Substratrückseite und Auflagefläche 62 herzustellen. In den so abgeschlossenen Raum 57 wird während der Bearbeitung des Substrats 8 Helium oder ein anderes geeignetes Gas zur Erhöhung der Wärmeleitfähigkeit zwischen Substrat 8 und Auflageplatte 44 eingeblasen. Zum Be- und Entladen des Substrats 8 wird der Käfig 46 durch Ausfahren der drei Hubvorrichtungen 40 in die Position "oben" gefahren. Die Hubvorrichtungen 40 werden dabei über einen Zahnriemen 42 angetrieben. In der Position "oben" des Käfigs 46 ragen die drei Hubstifte 47 aus der Platte 44 heraus und tragen das Substrat 8. Zum Be- bzw. Entladen fährt eine geeignete Gabel oder ein Be- und Entladearm 7 durch einen Schlitz 58 zwischen den Abstandstücken 59, 59' des Käfigs 46 - in der Zeichnung nicht dargestellt - in den Zwischenraum zwischen Substratrückseite und Auflageplatte 44. Nach Einfahren des Be-/Entladearms 7 wird der Käfig 46 in die Position "mittel" abgesenkt. Dies geschieht durch Herunterfahren der drei Hubvorrichtungen 40. In dieser Position sind die Hubstifte 47 schon so weit abgesenkt, daß das Substrat 8 frei auf dem Be-/Entladearm 7 liegt. Durch Herausfahren des Be-/Entladearms 7 samt daraufliegendem Substrat 8 wird die Vorrichtung entladen. Die Beladung erfolgt in umgekehrter Reihenfolge.

Es sei noch erwähnt, daß die Stößel 51 vom Spindel-Mutter-Trieb 78 bewegt werden, der über das Zahnrad 87 antreibbar ist. Auf der Hohlwelle 45 ist das Zahnrad 83 aufgepreßt, das mit dem Zahnriemen 81 zusammenwirkt. Die Kühlmittelkanäle 63, 64, 65 im Inneren der Hohlwelle 45 sind mit Hilfe von dünnwandigen Rohren 90, 91 voneinander getrennt und einerseits über Ringkanäle mit den Rohrleitungen 69, 70, 71 und andererseits mit den Kühlkanälen 73, 74, 75 verbunden. Mit 96 ist ein Flanschteil bezeichnet, das Teil der Hohlwelle 45 ist.

## Auflistung der Einzelteile

| | |
|---|---|
| 1 | Vakuumkammer |
| 2 | Ionenquelle |
| 3 | Pumpstand |
| 4 | Substrattisch |
| 5 | Substrathalter |
| 6 | Schleusentür |
| 7 | Be- und Entladearm |
| 8 | Probe, Substrat |
| 10 | Haltearm |
| 12 | Ionenstrahl |
| 13 | Holwelle |
| 14 | Auflageplatte |
| 15, 15', 15" | Kühlwassserkanal |
| 16 | Hubstange |
| 17 | Käfig |
| 18, 18', 18" | Hubstift |
| 19, 19', 19" | Abstandsstück |
| 20, 20' | Gleitlager |
| 21 | Balg |

| 22 | Innenkante |
|---|---|
| 23, 23′ | Lager |
| 24 | Dichtung |
| 25 | Drehdurchführung |
| 26 | Zahnrad |
| 27 | Zahnrad |
| 28 | Motor-Getriebeeinheit |
| 29 | Drehgeber |
| 30 | pneumatischer Zylinder |
| 31 | pneumatischer Zylinder |
| 32 | Differentialhebel |
| 33 | Drehlager |
| 34, 34′, 34″ | Auflagenoppen |
| 35 | Spannring |
| 36 | Auflagefläche |
| 37 | Öffnung |
| 38 | Schwenkachse |
| 39 | Flansch |
| 40, 40′, 40″ | Hubvorrichtung |
| 41 | Elektromotor |
| 42 | Zahnriemen |
| 43 | Durchführung |
| 44 | Auflageplatte |
| 45 | Hohlwelle |
| 46 | Käfig |
| 47, 47′, 47″ | Hubstift |
| 48 | Ring, Spannring |
| 49 | Drehachse |
| 50 | |
| 51 | Stößel |
| 52 | Substrattisch |
| 53 | Substrathalter |
| 54 | Blattfeder |
| 55 | Dichtung |
| 56 | Dichtung |
| 57 | Raum |
| 58 | Schlitz, Öffnung für Be- und Entladearm |
| 59, 59′ | Abstandsstück |
| 60 | Bodenplatte |
| 61 | Bodenplatte |
| 62 | Auflagefläche |
| 63 | Kanal |
| 64 | Kanal |
| 65 | Kanal |
| 66 | Gaszulauk |
| 67 | Wasserablauf |
| 68 | Wasserzulauf |
| 69 | Wasserablauf |

| 70 | Wasserzulauf |
|---|---|
| 71 | Gaszulauf |
| 72 | Kühlkanal |
| 73 | Kühlkanal |
| 74 | Kühlkanal |
| 75 | Kühlkanal |
| 76 | Raum |
| 77 | Pneumatikzylinder |
| 78 | Spindel-Mutter-Trieb |
| 79 | Drehachse, Längsachse |
| 80 | Substrathalterung |
| 81 | Zahnriemen |
| 82 | Zahnrad |
| 83 | Zahnrad |
| 84 | Motor |
| 85, 85′ | Lager |
| 86 | Gehäusedeckel |
| 87 | Zahnrad |
| 88 | Kolbenstange |
| 89 | Kolbenstange |
| 90 | Rohr |
| 91 | Rohr |
| 92, 92′, 92″ | Durchbruch |
| 93, 93′, 93″ | Zapfen |
| 94 | Zahnrad |
| 95 | Schlitz, Öffnung für Be- und Entladearm |
| 96 | Flanschteil |

## Patentansprüche

1. Vorrichtung zur Halterung von Werkstücken, vorzugsweise von kreisscheibenförmigen, flachen Substraten (8) in einer Vakuumkammer(1) zum Zwecke der Oberflächenbehandlung, insbesondere zum reaktiven Ionenätzen oder zum Beschichten mit Hilfe von Kathodenzerstäubung, **gekennzeichnet durch** eine mit einer Hohlwelle (13, 45) verbundenen Auflageplatte (14, 44), einer unterhalb der Auflageplatte (14, 44) angeordneten Bodenplatte (60, 61), die zusammen mit Abstandstücken (19, 19′, 19″; 59, 59′) und einem Spannring (35, 48) oder sich etwa parallel zur ebene der Auflageplatte erstreckenden Fingern, einen die Auflageplatte (14, 44) teilweise umschließenden, koaxial zur Auflageplatte (14, 44) gehaltenen, verschiebbaren Käfig (17, 46) bildet, wobei das über einen in der Seitenwandung des Käfigs (17, 46) zwischen zwei Abstandstücken ,(19, 19′, 19″; 59, 59′) einführbare Substrat (8) auf der Auflagefläche (36, 62) der Auflageplatte (14, 44) ablegbar ist und dort vom Spannring (35, 48) oder den Fingern nach einer Relativbewegung zwischen der Auflageplatte (14, 44) und dem Käfig (17; 46) arretierbar ist.

2. Vorrichtung nach Anspruch 1, **dadurch gekennzeichnet,** daß die die Auflageplatte (14;44) tragende Hohlwelle (13; 45) mit Kanälen (15, 15′; 63, 64, 65) versehen ist, die einerseits mit Zu- und Ablaufleitungen (66 bis 71) und andererseits mit Kühlkanälen (72 bis 75) in der Auflageplatte (14; 44) oder einem Raum (57; 6) korrespondieren, der zwischen der Auflagefläche (36; 62) und dem Substrat (8) gebildet ist.

3. Vorrichtung nach Anspruch 1, **dadurch gekennzeichnet,** daß der Käfig (17; 61) über ein oder mehrere Stellglieder, beispielsweise über einen Hydraulik- oder Pneumatikzylinder (77) oder über mit Spindel-Mutter-Trieben (78) ausgestattete Hubvorrichtungen (40) gegenüber der Auflageplatte (14; 44), verschiebbar ist.

4. Vorrichtung nach den Ansprüchen 1 bis 3, **gekennzeichnet durch** einen Be- und entladearm (7), der quer zur Längsachse (49, 79) der Hohlwelle (13; 45) bis in eine Öffnung oder einen Schlitz (58, 95) verfahrbar ist, der von zwei benachbarten Abstandsstücken (19′, 19″ bzw. 59′), dem Spannring (35; 48) und der Bodenplatte (60; 61) des Käfigs (17; 46) gebildet ist und dessen der Vorrichtung zugekehrtes ende mit einer Halterung (80) für das Substrat (8) versehen ist, wobei die Halterung (80) Öffnungen oder Aussparungen oder eine Konfiguration aufweist, durch die Hubstifte (18, 18′, 18″ bzw. 47) hindurchgreifen, die auf der Bodenplatte (60; 61) des Käfigs (17; 46) angeordnet sind und dabei mit dem Substrat (8) in Kontakt treten und dieses von der Halterung (80) abheben bzw. auf diese ablegen.

5. Vorrichtung nach einem oder mehreren der vorhergehenden Ansprüche, **dadurch gekennzeichnet,** daß die Hohlwelle (13; 45) über einen Zahn- oder Zahnriementrieb (26, 27 bzw. 81, 82, 83) von einem Motor (28; 84) antreibbar ist und hierzu in einem Lager (23, 23′ bzw. 85, 85′) im Gehäusedeckel (86) gehalten ist, der Teil eines an der Vakuumkammerwand (1) angeordneten Gehäuses (4) ist, das der Halterung des Substrattisches (5, 52) dient.

6. Vorrichtung nach einem oder mehreren der vorhergehenden Ansprüche, **dadurch gekennzeichnet,** daß das Gehäuse (4) zur Halterung des Substrattisches (5, 25) um eine Achse (38) schwenkbar am Gestell der Vorrichtung gelagert ist, die nahe oder in der ebene der Auflagefläche (36; 62) der Auflageplatte (14; 44) verläuft.

7. Vorrichtung nach einem oder mehreren der vorhergehenden Ansprüche, **dadurch gekennzeichnet,** daß der Käfig (17 bzw. 46) mit seiner Bodenplatte (60 bzw. 61) auf mindestens einer Hubstange (16) oder einem Stößel (51) abgestützt ist, wobei Hubstange (16) oder Stößel (51) von einem Hubzylinder (77) oder einer mechanisch arbeitenden, über einen Zahnriemen (42) von einem Motor (41) angetriebenen Hubvorrichtung (40) bewegbar sind.

8. Vorrichtung nach Anspruch 7, **dadurch gekennzeichnet,** daß die Hubstange (16) auf einem zweiarmigen Differentialhebel (32) abgestützt ist, dessen enden mit den Kolbenstangen (88, 89) von Zylindern (30, 31) zusammenwirken, die in einen Druckmittelkreislauf eingeschaltet und an Ansteuerventile angeschlossen sind.

9. Vorrichtung nach einem oder mehreren der vorherhendenn Ansprüche, **dadurch gekennzeichnet,** daß die Hohlwelle (45) mehrere konzentrische Kanäle (63, 64, 65) aufweist, die durch mehrere dünnwandige, konzentrisch zueinander angeordnete Rohre (90, 91) voneinander getrennt sind und die in umlaufende Nuten und-/oder in einen zentralen Ausgang münden.

10. Vorrichtung nach einem oder mehreren der vorherhenden Ansprüche, **dadurch gekennzeichnet,** daß die Bodenplatte (60) des Käfigs (17) Öffnungen oder Durchbrüche (92, 92′, 92″) aufweist, durch die das kronenförmig ausgebildete, käfigseitige ende der Hohlwelle (13) mit seinen Zapfen (93, 93′, 93″) hindurchgreift, wobei die enden der Zapfen (93, 93′, 93″) fest mit der Auflageplatte (14) in Wirkverbindung stehen.

11. Vorrichtung nach einem oder mehreren der vorherhenden Ansprüche, **dadurch gekennzeichnet,** daß an der der Auflagefläche (36; 62) der Auflageplatte (14; 44) Kanäle, (15′; 65) einmünden, über die ein das Substrat (8) kühlendes Gas in den Zwischenraum oder die Kammer (76; 57), die vom Substrat (8) und der Auflageplatte (14; 44) zumindest zeitweise begrenzt wird, einströmt.

## Claims

1. A device for holding workpieces, preferably disc-shaped flat substrates (8), in a vacuum chamber (1) for the purpose of surface treatment, more particularly for reactive ionic etching or for coating by cathode sputtering, characterised by a bearing plate (14, 44) connected to a hollow shaft (13, 45) and by a baseplate (60, 61) which is disposed under the bearing plate (14, 44) and which co-operates with spacer members (19, 19′, 19″; 59, 59′) and a clamping ring (35, 48) or fingers extending approximately parallel to the plane of the bearing plate to form a movable cage (17, 46) which partly surrounds the bearing plate (14, 44) and is held coaxially therewith, and the substrate (8), which is insertable between two spacer members (19, 19′, 19″; 59, 59′) over a .... in the side wall of the cage (17, 46), is adapted to be deposited on the bearing surface (36, 62) of the bearing plate (14, 44) and is lockable there by the clamping ring (35, 48) or the fingers after the bearing plate (14, 44) has moved relative to the cage (17; 46).

2. A device according to claim 1, characterised in that the hollow shaft (13; 45) supporting the bearing plate (14; 44) is formed with ducts (15, 15′; 63, 64, 65) which correspond at one end to inlet and outlet lines (66 to 71) and at the other end to cooling ducts (72 to 75) in the bearing plate (14; 44) or to a chamber (57; 6) formed between the bearing surface (36; 62) and the substrate (8).

3. A device according to claim 1, characterised in that the cage (17; 61) is movable relative to the bearing plate (14; 44) by one or more actuators, e.g. by a hydraulic or pneumatic cylinder (77) or by lifting devices (40) equipped with spindle-nut drives.

4. A device according to claims 1 to 3, characterised by a loading and unloading arm (7) which is movable transversely to the longitudinal axis (49, 79) of the hollow shaft (13; 45) up to an opening or a slot (58, 95) formed by two adjacent spacer members (19′, 19″ or 59′), the clamping ring (35; 48) and the baseplate (60; 61) of the cage (17; 46), the end of the arm facing the device being provided with a holder (80) for the substrate (8), the holder (80) having openings or recesses or a configuration through which the lifting pins (18, 18', 18" or 47) disposed on the baseplate (60; 61) of the cage (17; 46) extend and thus come into contact with the substrate (8) and lift it off or deposit it on the holder (80).

5. A device according to one or more of the preceding claims, characterised in that the hollow shaft (13; 45) is drivable by a motor (28; 84) via a toothed or toothed-belt drive (26, 27 or 81, 82, 83) and to this end is held in a bearing (23, 23' or 85, 85') in the casing cover (86), which is a part of a casing (4) disposed on the vacuum chamber wall (1) and is used to hold the substrate table(5, 52).

6. A device according to one or more of the preceding claims, characterised in that the casing (4), for the purpose of holding the substrate table (5, 25), is mounted on the frame of the device so as to be pivotable around an axis (38) which extends near to or in the plane of the bearing surface (36; 62) of the bearing plate (14; 44).

7. A device according to one or more of the preceding claims, characterised in that the baseplate (60 or 61) of the cage (17 or 46) is mounted on at least one lifting mechanism (16) or a push rod (51), the lifting mechanism (16) or the push rod (51) being movable by a lifting cylinder (77) or by a mechanically operating lifting device (40) driven by a motor (41) via a toothed belt (42).

8. A device according to claim 7, characterised in that the lifting mechanism (16) is mounted on a two-armed differential lever (32), the ends of which co-operate with the piston-rods (88, 89) of cylinders (30, 31) which are disposed in a pressure-medium circuit and are connected to triggering valves.

9. A device according to one or more of the preceding claims, characterised in that the hollow shaft (45) has a number of concentric ducts (63, 64, 65) which are separated by a number of concentric thin-walled tubes (90, 91) and open into peripheral grooves or into a central outlet.

10. A device according to one or more of the preceding claims, characterised in that the baseplate (60) of the cage (17) has openings or apertures (92, 92', 92") through which journals (93, 93', 93") in the annular cage-side end of the hollow shaft (13) extend, the ends of the journals (93, 93', 93") being permanently in operative connection with the bearing plate (14).

11. A device according to one or more of the preceding claims. characterisd in that ducts (15'; 65) open into the bearing surface (36; 62) of the bearing plate (14; 44), and a gas for cooling the substrate (8) flows through them into the space or the chamber (76; 57), which is at least intermittently bounded by the substrate (8) and the bearing plate (14; 44).

## Revendications

1. Dispositif destiné à tenir des pièces, de préférence des substrats plats (8) présentant la forme de disques circulaires, dans une chambre à vide (1) pour réaliser un traitement de surface, notamment l'attaque par ions réactifs ou le revêtement à l'aide de pulvérisation cathodique, caractérisé par un plateau d'appui (14, 44) relié à un arbre creux (13, 45), une plaque de fond (60, 61) disposée au-dessous de la plateau d'appui (14, 44), qui forme, en combinaison avec des entretoises (19, 19', 19" ; 59, 59') et une couronne de serrage (35, 48), ou des doigts s'étendait à peu près parallèlement au plan du plateau d'appui, une cage (17, 46) qui entoure partiellement le plateau d'appui (14, 44), qui est tenue coaxialement au plateau d'appui (14, 44) et qui et mobile en translation, le substrat (8), qui peut être introduit à travers une fente prévue dans la paroi latérale de la cage (17, 46), entre deux entretoises (19, 19', 19" ; 59, 59') pouvant être déposé sur la surface d'appui (36, 62) du plateau d'appui (14, 44) et là, être immobilisé par la couronne de serrage (35, 48) ou par les doigts à la suite d'un déplacement relatif entre le plateau d'appui (14, 44) et la cage (17, 46).

2. Dispositif selon la revendication 1, caractérisé en ce que l'arbre creux (13 ; 45) qui porte le plateau d'appui (14 ; 44) est muni de canaux (15, 15' ; 63, 64, 65) qui correspondent, d'une part, à des conduites d'arrivée et de départ (66 à 71) et, d'autre part, à des canaux de refroidissement (72 à 75) prévus dans le plateau d'appui et qui sont formés entre la surface d'appui (36, 62) et le substrat (8).

3. Dispositif selon la revendication 1, caractérisé en ce que la cage (17 ; 61) peut être déplacée en translation par rapport au plateau d'appui (14 ; 44) au moyen d'un ou de plusieurs actionneurs, par exemple au moyen d'un vérin hydraulique ou pneumatique (77) ou au moyen de dispositifs élévateurs (40) équipés de mécanismes à vis et écrou (78).

4. Dispositif selon les revendications 1 à 3, caractérisé par un bras de chargement et de déchargement (7) qui peut se déplacer transversalement à l'axe longitudinal (49, 79) de l'arbre creux (13 ; 45) jusqu'à s'engager dans une ouverture ou une fente (58, 95) qui est formée par deux entretoises adjacentes (19', 19" ou 59'), la couronne de serrage (35 ; 48) et la plaque de fond (60 ; 61) de la-cage (17 ; 46), et dont l'extrémité dirigée vers le dispositif est munie d'un support (80) pour le substrat (8), le support (80) présentant des ouvertures ou évidements, ou une configuration, à travers lesquelles passent les doigts élévateurs (18, 18', 18" ou 47) qui sont agencés sur la plaque de fond (60 ; 61) de la cage (17 ; 46) et, dans ce mouvement, entrent en contact avec le substrat (8) et soulèvent ce dernier du support (80) ou le déposent sur ce support.

5. Dispositif selon une ou plusieurs des revendications précédentes, caractérisé en ce que l'arbre creux (13 ; 45) peut être entraîné par un moteur (28 ; 84) par l'intermédiaire d'une transmission à denture ou à courroie crantée (26, 27 ou 81, 82, 83) et, à cet effet, est tenu dans un palier (23, 23′ ou 85, 85′) prévu dans le couvercle (86) du boîtier, couvercle qui fait partie d'un boîtier (4) agencé contre la paroi (1) de la chambre à vide, ce boîtier servant à supporter la table porte-substrat.

6. Dispositif selon une ou plusieurs des revendications précédentes, caractérisé en ce que le boîtier (4) servant à supporter la table porte-substrat (5, 25) est monté pour tourner sur le bâti du dispositif autour d'un axe (38) qui s'étend à proximité ou dans le plan de la surface d'appui (36 ; 62) du plateau d'appui (14 ; 44).

7. Dispositif selon une ou plusieurs des revendications précédentes, caractérisé en ce que la cage (17 ou 46) prend appui par sa plaque de fond (60 ou 61) sur au moins une tige élévatrice (16) ou un poussoir (51), la tige élévatrice (16) ou le poussoir (51) pouvant être mis en mouvement par un vérin (77) ou par un dispositif élévateur (40) travaillant mécaniquement, entraîné par un moteur (41) par l'intermédiaire d'une courroie crantée (42).

8. Dispositif selon la revendication 7, caractérisé en ce que la tige élévatrice (16) prend appui sur un levier différentiel (32) à deux bras dont les extrémités coopèrent avec les tiges de pistons (88, 89) de vérins (30, 31) qui sont intercalés dans un circuit de fluide de pression et raccordés à des valves de commande.

9. Dispositif selon une ou plusieurs des revendications précédentes, caractérisé en ce que l'arbre creux (45) présente plusieurs canaux concentriques (63, 64) qui sont séparés les uns des autres par plusieurs tubes à paroi mince (90, 91) et qui débouchent dans des gorges circonférentielles et/ou dans une sortie centrale.

10. Dispositif selon une ou plusieurs des revendications précédentes, caractérisé en ce que la plaque de fond (60) et la cage (17) présentent des ouvertures ou trous traversants (92, 92′, 92″) à travers lesquels l'extrémité côté cage de l'arbre creux (13), présentant la forme d'une couronne, est enfilée par ses tenons (93, 93′, 93″), les extrémités des tenons (93, 93′, 93″) étant reliées solidairement au plateau d'appui (14).

11. Dispositif selon une ou plusieurs des revendications précédentes, caractérisé en ce qu'au niveau de la surface d'appui (36, 62) du plateau d'appui (14 ; 44), débouchent des canaux (15′; 65) par lesquels un gaz de refroidissement du substrat (8) pénètre dans l'espace intercalaire ou la chambre (76 ; 57) qui est délimitée, du moins temporairement, par le substrat (8) et le plateau d'appui (14 ; 44).

# FIG.1

FIG.2

FIG.3

FIG.4